# EUROPÄISCHE PATENTANMELDUNG

(11) **EP 1 734 372 A1**
(43) Veröffentlichungstag der Anmeldung: **20.12.2006**
(21) Anmeldenummer: 06115432.4
(22) Anmeldetag: 14.06.2006
(51) Int. Cl.: G01R 31/02, G01R 31/06, G01R 31/34, E05F 15/10, H02P 3/12

(54) **Antrieb zum Betätigen eines beweglichen Flügels, insbesondere einer Tür**

(30) Priorität: 16.06.2005 DE 102005028058
(71) Anmelder: GEZE GmbH, 71229 Leonberg (DE)
(72) Erfinder: Dr. Hucker, Matthias, 76359, Marxzell (DE); Katz, Eugen, 71263, Weil der Stadt-Schafhausen (DE); Horz, Uwe, 71229, Leonberg (DE)

(57) **Zusammenfassung**

Es wird ein Antrieb zum Betätigen eines beweglichen Flügels, insbesondere einer Tür, beschrieben. In einem Motorstromkreis ist ein Elektromotor angeordnet, dessen Abtriebsglied über eine Kraftübertragungseinrichtung mit dem Flügel in Wirkverbindung steht, so dass eine Bewegung des Abtriebsglieds eine Bewegung des Flügels bewirkt. Eine Steuerungseinrichtung dient zur Ansteuerung des Antriebsmotors. Durch eine Bremseinrichtung ist die Bewegung des Flügels bremsbar, indem der Elektromotor als Generator betreibbar ist, wobei die Ausgangsspannung des generatorisch betriebenen Elektromotors an einen in einem Bremsstromkreis angeordneten, elektrischen Widerstand angelegt wird. Die Steuerungseinrichtung ist so ausgebildet, dass zyklische Prüfungen des Motorstromkreises und des Bremsstromkreises durchführbar sind, wobei bei Erkennung einer Störung des Motorstromkreises bzw. des Bremsstromkreises eine Sicherheitsreaktion erfolgt.

## Beschreibung

Die Erfindung betrifft einen Antrieb zum Betätigen eines beweglichen Flügels, insbesondere einer Tür, nach dem Oberbegriff des Patentanspruchs 1.

Aus der DE 41 00 335 A1 ist ein Antrieb zum Betätigen eines beweglichen Schwenkflügels einer Tür bekannt. Das Abtriebsglied eines in einem Motorstromkreis angeordneten Elektromotors steht über eine Kraftübertragungseinrichtung mit dem Flügel in Wirkverbindung, so dass eine Bewegung des Abtriebsglieds eine Bewegung des Flügels bewirkt. Eine mechanische Federeinrichtung stellt die Schließung des Flügels bei Ausfall der elektrischen Energieversorgung sicher. Um in diesem Falle ein gedämpftes Schließen des Flügels zu gewährleisten, ist eine Bremseinrichtung vorgesehen, indem der Elektromotor als Generator betreibbar ist. Die Ausgangsspannung des generatorisch betriebenen Elektromotors wird an einen in einem Bremsstromkreis angeordneten, elektrischen Widerstand angelegt. Im Ausführungsbeispiel der genannten Druckschrift wird der Elektromotor hierzu kurzgeschlossen, so dass die Ausgangsspannung des generatorisch betriebenen Elektromotors an einem niedrigen ohmschen Widerstand anliegt. Falls es zu einer Unterbrechung des Motorstromkreises oder des Bremsstromkreises kommt, ist der generatorisch betriebene Elektromotor nicht mehr mit dem Widerstand verbunden, so dass die Bremseinrichtung wirkungslos ist. Auch eine Unterbrechung der Motorwicklungen kann zum Ausfall der Bremseinrichtung führen. Die Steuerungseinrichtung des in der Druckschrift beschriebenen Antriebs erfasst derartige Störungen nicht.

Der Erfindung liegt die Aufgabe zugrunde, einen gattungsgemäßen Antrieb so weiterzuentwickeln, dass Störungen des Motorstromkreises und des Bremsstromkreises erkannt werden.

Die Aufgabe wird durch die Merkmale des Patentanspruchs 1 gelöst. Die Unteransprüche bilden vorteilhafte Ausgestaltungsmöglichkeiten der Erfindung.

Die Steuerungseinrichtung des Antriebs ist so ausgebildet, dass zyklische Prüfungen des Motorstromkreises und des Bremsstromkreises durchführbar sind, wobei bei Erkennung einer Störung des Motorstromkreises bzw. des Bremsstromkreises eine Sicherheitsreaktion erfolgt. Hierdurch ist einerseits die Erfassung einer Störung sichergestellt, und andererseits wird der Antrieb vor Beschädigungen geschützt, welche durch einen sich unkontrolliert bewegenden Flügel hervorgerufen werden können.

Die Steuerungseinrichtung kann einen Testsignaleingang für ein bei der Prüfung des Motorstromkreises bzw. des Bremsstromkreises generierbares Testsignal aufweisen.

Da die Steuerungseinrichtung einen Ausgang zur Ansteuerung des Elektromotors aufweist, kann das Ausgangssignal dieses Ausgangs zur Prüfung des Motorstromkreises bzw. Bremsstromkreises verwendet werden, womit für das Testsignal kein weiterer, separater Ausgang der Steuerungseinrichtung erforderlich ist.

Um einen möglichen Fehler genau lokalisieren zu können, ist es zweckmäßig, den Motorstromkreis und den Bremsstromkreis separat voneinander zu prüfen. Dies kann dadurch erreicht werden, dass die Bremsschaltung eine Umschalteinrichtung aufweist, durch welche der Motorstromkreis mit dem Bremsstromkreis elektrisch verbindbar oder von diesem entkoppelbar ist.

Eine einfach aufgebaute und zugleich zuverlässige Umschalteinrichtung kann dadurch erreicht werden, dass sie ein Relais mit einem Relaiskontakt aufweist. Zur Ansteuerung des Relais kann die Steuerungseinrichtung einen Ausgang aufweisen.

Die Bremsschaltung kann eine weitere, als Umschalter ausgebildete Schaltereinrichtung aufweisen, durch welche die Stromrichtung im Bremsstromkreis umschaltbar ist. Neben einer Umkehrung der Stromflussrichtung im Bremsstromkreis ermöglicht diese Schaltereinrichtung auch das Erzeugen verschiedener Testschaltungen innerhalb der Bremsschaltung.

Die Bremsschaltung kann einen aus zwei in Reihe geschalteten Widerständen gebildeten Spannungsteiler aufweisen. Der Spannungsteiler kann beispielsweise zwischen einem Punkt des Bremsstromkreises und dem Massepotenzial angeordnet sein. Der Testsignaleingang der Steuerungseinrichtung kann mit dem Mittenabgriff des Spannungsteilers verbunden sein. Somit lassen sich mittels des Spannungsteilers Potenziale an bestimmten Punkten des Bremsstromkreises erfassen und in ein für den Testsignaleingang der Steuerungseinrichtung erfassbares Signal umsetzen. Parallel zu dem zwischen dem Mittenabgriff und dem Massepotenzial angeordneten Widerstand des Spannungsteilers kann ein Kondensator angeordnet sein, welcher der Glättung der hier abgreifbaren Spannung dient.

Die Abtriebswelle des Elektromotors oder ein mit der Abtriebswelle des Elektromotors bewegungsverbundenes Teil des Antriebs kann mit einer Bremseinrichtung verbunden sein. Die Steuerungseinrichtung kann einen Ausgang zur Ansteuerung der Bremseinrichtung aufweisen. Die Bremseinrichtung stellt sicher, dass Bewegungen der Abtriebswelle des Elektromotors und somit des angeschlossenen Flügels sicher abbremsbar und ggf. blockierbar sind, insbesondere bei der Erkennung von sicherheitsrelevanten Störungen oder auch bei der Durchführung der zyklischen Prüfungen.

Zur Erfassung ihrer Bewegung kann die Abtriebswelle des Elektromotors mit einer Drehgebereinrichtung verbunden sein, wobei die Steuerungseinrichtung einen Eingang für ein Signal der Drehgebereinrichtung aufweisen kann.

Außerdem kann die Steuerungseinrichtung einen Eingang für ein Signal aufweisen, welches den den Elektromotor durchfließenden Strom anzeigt.

Im Nachfolgenden wird ein Ausführungsbeispiel in der Zeichnung anhand der Figuren näher erläutert.

### Dabei zeigen:

- Fig. 1: eine schematisch dargestellte Schaltungsanordnung eines erfindungsgemäßen Antriebs in einem ersten Betriebszustand;
- Fig. 2: die Schaltungsanordnung gemäß Fig. 1 in einem ersten Prüfungszustand;
- Fig. 3: die Schaltungsanordnung gemäß Fig. 1 in einem zweiten Prüfungszustand;
- Fig. 4: die Schaltungsanordnung gemäß Fig. 1 in einem dritten Prüfungszustand;
- Fig. 5: die Schaltungsanordnung gemäß Fig. 1 in einem vierten Prüfungszustand;
- Fig. 6: die Schaltungsanordnung gemäß Fig. 1 in einem fünften Prüfungszustand;
- Fig. 7: eine weitere erfindungsgemäße, gegenüber den Fig. 1 bis 6 abgewandelte Schaltungsanordnung eines erfindungsgemäßen Antriebs in einem ersten Betriebszustand;
- **Fig. 8**: die Schaltungsanordnung gemäß Fig. 7 in einem ersten Prüfungszustand;
- **Fig. 9**: die Schaltungsanordnung gemäß Fig. 7 in einem zweiten Prüfungszustand;
- **Fig. 10**: die Schaltungsanordnung gemäß Fig. 7 in einem dritten Prüfungszustand.

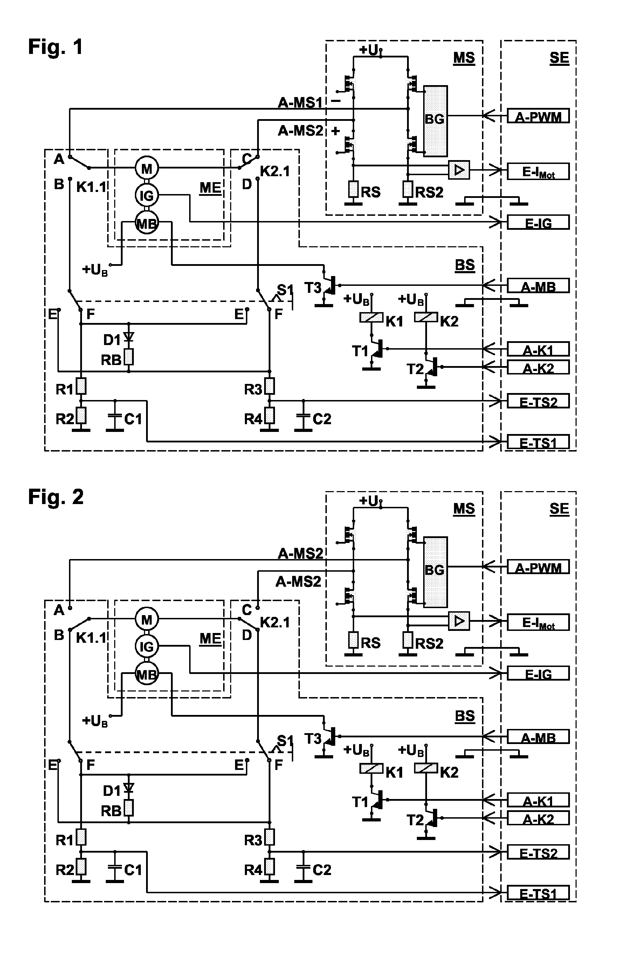

Die Fig. 1 zeigt eine Schaltungsanordnung des Antriebs in einem ersten Betriebszustand. Die Bauelemente der Schaltungsanordnung sind mit gestrichelter Umrahmung zu Baueinheiten zusammengefasst dargestellt: Eine Motoreinheit ME, eine Motorschaltung MS, eine Steuerungseinrichtung SE und eine Bremsschaltung BS. Diese Zusammenfassungen dienen lediglich der besseren Übersichtlichkeit der Darstellung und bedeuten nicht notwendigerweise eine tatsächlich derartig ausgeführte räumliche Zusammenfassung der Bauelemente, beispielsweise auf separaten Platinen.

Die Steuerungseinrichtung SE weist einen Ausgang A-PWM zur Ausgabe eines pulsweitenmodulierten Signals auf. Dieses wird der Motorschaltung MS, welche unter anderem einen Brückengleichrichter BG und eine Transistorbrücke aufweist, zugeleitet.

Die Ausgangsklemmen A-MS1, A-MS2 der Motorschaltung MS sind mit Relaiskontakten K1.1, K2.1 der Bremsschaltung BS verbunden. Die Relaiskontakte K1.1, K2.1 sind durch die Relais K1, K2 zwischen jeweils zwei Schaltstellungen A, B, C, D umschaltbar. Die Schaltspulen der Relais K1, K2 sind, jeweils in Reihe geschaltet mit der Drain-Source-Strecke eines Transistors T1, T2, zwischen einer Betriebsspannung U_{B} und dem Massepotenzial geschaltet. Die Gate-Anschlüsse der Transistoren T1, T2 sind jeweils mit einem Ausgang A-K1, A-K2 der Steuerungseinrichtung SE verbunden. Bei fehlendem Signal der Ausgänge A-K1, A-K2 sind die Transistoren T1, T2 jeweils sperrend, so dass die Schaltspulen der Relais K1, K2 nicht stromdurchflossen sind und die Relaiskontakte K1.1, K2.1 sich in den in der Zeichnung unteren Schaltstellungen B, D befinden. Beim Vorliegen eines Ausgangssignals eines oder beider Ausgänge A-K1, A-K2 der Steuerungseinrichtung SE wird die Drain-Source-Strecke des jeweiligen Transistors T1, T2 leitend, was eine Bestromung der Schaltspule des jeweiligen Relais K1, K2 und somit ein Umschalten des jeweiligen Relaiskontakts K1.1, K2.1 von der einen Schaltstellung B, D zu der zweiten Schaltstellung A, C bewirkt.

Zwischen den Relaiskontakten K1.1, K2.1 der Relais K1, K2 ist die Motoreinheit ME angeordnet. Die Motoreinheit umfasst einen in dem Motorstromkreis angeordneten, als Gleichstrommotor ausgebildeten Elektromotor M, dessen Drehzahl mit einer Drehgebereinrichtung IG erfassbar ist. Das Ausgangssignal der Drehgebereinrichtung IG, welche beispielsweise als Inkrementalgeber ausgebildet sein kann, wird dem Eingang E-IG der Steuerungseinrichtung SE zugeleitet, so dass in der Steuerungseinrichtung SE die Drehzahl des Elektromotors und bei hinterlegten Antriebsparametern auch die Stellung des angeschlossenen Flügels erfassbar sind.

Die Motoreinheit ME umfasst außerdem eine mechanische Bremseinrichtung MB, welche mit einer Abtriebswelle des Elektromotors M gekoppelt ist. Die Bremseinrichtung MB kann als Magnetbremse ausgebildet sein, wobei die Spule des Elektromagneten in Reihe mit der Drain-Source-Strecke eines Transistors T3 zwischen einer Betriebsspannung U_{B} und dem Massepotenzial geschaltet ist. Der Gate-Anschluss des Transistors T3 ist mit einem Ausgang A-MB der Steuerungseinrichtung SE verbunden. Bei fehlendem Signal des Ausgangs A-MB ist der Transistor T3 sperrend, so dass die Spule der Magnetbremse nicht stromdurchflossen ist und die Bremse folglich keine Bremswirkung hat. Beim Vorliegen eines Ausgangssignals des Ausgangs A-MB der Steuerungseinrichtung SE wird die Drain-Source-Strecke des Transistors T3 leitend, was eine Bestromung der Spule der Magnetbremse und somit deren Bremswirkung auf den Elektromotor M bewirkt.

Die Bremsschaltung BS weist einen Bremsstromkreis auf, welcher bei den in der Zeichnung unteren Schaltstellungen B, D der Relaiskontakte K1.1, K2.1 der Relais K1, K2 mit dem Elektromotor M verbunden ist. Im Bremsstromkreis ist eine Reihenschaltung einer Diode D1 und eines Bremswiderstands RB angeordnet. Der Bremswiderstand RB ist der Lastwiderstand für den generatorisch betriebenen Elektromotor M. Die Diode D1 bewirkt, dass der Bremsstromkreis nur in einer Stromrichtung wirksam ist. Die Funktion des Bremsstromkreises ist also von der Polarität der an ihm anliegenden Spannung abhängig. Die gewählte Darstellung mit Diode D1 und Bremswiderstand RB steht stellverstretend für alle Bremsschaltungen mit polaritätsabhängiger Funktion, d.h. es sind in dem Bremsstromkreis auch abweichende Bauelemente mit polaritätsabhängig unterschiedlichem Verhalten denkbar.

Zwischen den Relaiskontakten K1.1, K2.1 der Relais K1, K2 und dem Bremsstromkreis ist eine zweipolig zwischen zwei Schaltstellungen E, F umschaltbare Schaltereinrichtung S1 angeordnet, durch welche die Polarität der an dem Bremsstromkreis anliegenden Spannung umschaltbar ist, so dass der Bremsstromkreis für beide Drehrichtungen des generatorisch betriebenen Elektromotors wirksam geschaltet werden kann.

Zur Durchführung von Prüfungen sind in der Bremsschaltung BS außerdem zwei Prüfspannungsabgriffe vorhanden. Diese werden gebildet durch Spannungsteiler, welche jeweils aus zwei in Reihe geschalteten, hochohmigen Widerständen R1, R2, R3, R4 bestehen. Die Spannungsteiler sind jeweils zwischen dem Massepotenzial und einem Bezugspunkt des Bremsstromkreises geschaltet, wobei der Bezugspunkt des ersten, in der Zeichnung linken Spannungsteilers auf der einen Seite der aus der Diode D1 und dem Bremswiderstand RB gebildeten Reihenschaltung liegt und der Bezugspunkt des zweiten, in der Zeichnung rechten Spannungsteilers auf deren anderer Seite. Der zwischen den Widerständen R1, R2 des ersten Spannungsteilers befindliche Mittenabgriff ist mit einem Testsignaleingang E-TS1 der Steuerungseinrichtung SE verbunden. Ein zwischen dem Testsignaleingang E-TS1 und dem Massepotenzial angeordneter Kondensator C1 glättet die am Testsignaleingang E-TS1 anliegende Prüfspannung. In entsprechender Weise ist der zwischen den Widerständen R3, R4 des zweiten Spannungsteilers befindliche Mittenabgriff mit einem weiteren Testsignaleingang E-TS2 der Steuerungseinrichtung SE verbunden, wobei ein zwischen dem Testsignaleingang E-TS2 und dem Massepotenzial angeordneter Kondensator C2 die am Testsignaleingang E-TS2 anliegende Prüfspannung glättet.

Bei dem in dieser Abbildung dargestellten Betriebszustand liegt ein rein elektromotorischer Normalbetrieb des Antriebs vor. Beide Ausgänge A-K1, A-K2 der Steuerungseinrichtung SE sind aktiv und bewirken, dass die Relaiskontakte K1.1, K2.1 der Relais K1, K2 die in der Zeichnung oberen Schaltstellungen A, C eingenommen haben. Der Elektromotor M ist somit mit den Ausgangsklemmen A-MS1, A-MS2 der Motorschaltung MS verbunden und kann, abhängig vom Signal des Ausgangs A-PWM der Steuerungseinrichtung SE, in beiden Drehrichtungen betrieben werden. Die mechanische Bremseinrichtung MB ist nicht aktiv. Die weiteren Bauelemente der Bremsschaltung BS sind aufgrund der Schaltstellungen A, C der Relaiskontakte K1.1, K2.1 der Relais K1, K2 vom Elektromotor M elektrisch entkoppelt. Prüfungen der Bremsschaltung BS werden in diesem Betriebszustand noch nicht vorgenommen.

In der **Fig. 2** ist die Schaltungsanordnung in einem zweiten Betriebszustand des Antriebs dargestellt. Die Ausgänge A-K1, A-K2 der Steuerungseinrichtung SE sind jeweils inaktiv, so dass die Transistoren T1, T2 sperrend und die Schaltspulen der Relais K1, K2 nicht stromdurchflossen sind. Die Relaiskontakte K1.1, K2.1 der Relais K1, K2 befinden sich somit in den in der Zeichnung unteren Schaltstellungen B, D, so dass der Elektromotor M mit dem Bremsstromkreis der Bremsschaltung BS verbunden ist.

Wird eine mechanische Bewegung in das Abtriebsglied des Elektromotors M eingeleitet, beispielsweise durch eine mechanische Energiespeichereinrichtung, wird der Elektromotor M generatorisch betrieben und induziert hierbei eine Spannung, deren Höhe und Polarität von der Drehzahl und Drehrichtung des Elektromotors M abhängig ist. Die Motorspannung liegt in dem dargestellten Betriebszustand an der im Bremsstromkreis befindlichen Reihenschaltung aus der Diode D1 und dem Bremswiderstand RB an. Der Bremsstrom im Bremsstromkreis ist somit abhängig von der Drehrichtung und der Drehzahl des generatorisch betriebenen Elektromotors M sowie von den Parametern der Diode D1 und des Bremswiderstands RB.

Soll der Bremsstromkreis auch in der anderen generatorischen Drehrichtung des Elektromotors M wirksam sein, wird der Bremsstromkreis mittels der Schaltereinrichtung S1 durch Umschalten von der dargestellten Schaltstellung F in die andere Schaltstellung E umgepolt.

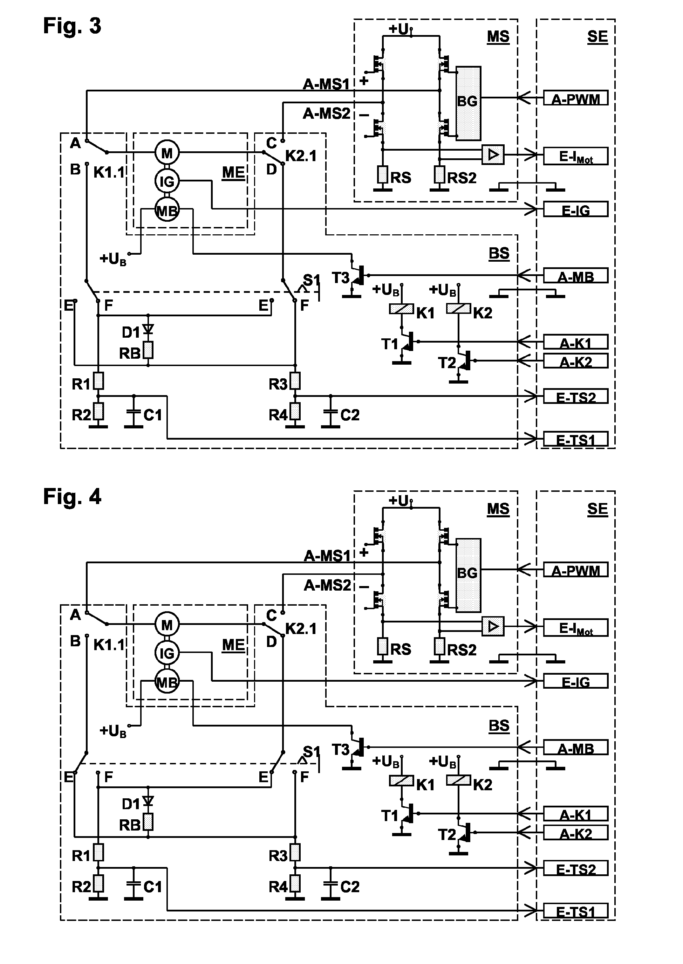

Im Falle einer Störung im Motorstromkreis oder im Bremsstromkreis ist eine Bremswirkung der Bremsschaltung BS nicht mehr gewährleistet, beispielsweise bei einer Unterbrechung einer Leitung der genannten Stromkreise oder im Elektromotor M. Um diese Störungen vor dem Auftreten einer gefährlichen Situation zu detektieren, sind zyklische Prüfungen des Motorstromkreises und des Bremsstromkreises vorgesehen. Die in den folgenden Abbildungen (Fig. 3 bis Fig. 6) dargestellten Betriebszustände beinhalten derartige Prüfungen:

In der **Fig. 3** ist ein einen ersten Prüfungsschritt enthaltender Betriebszustand der Schaltungsanordnung des Antriebs dargestellt. Die Steuerungseinrichtung SE aktiviert über ein Ausgangssignal ihres Ausgangs A-MB die mechanische Bremseinrichtung MB, so dass der Elektromotor M in seiner aktuellen Position blockiert wird. Über ihren Ausgang A-PWM gibt die Steuerungseinrichtung SE ein Signal an die Motorschaltung MS aus, welches ein an dem in der Zeichnung oberen Ausgang A-MS1 der Motorschaltung MS befindliches positives Potenzial bewirkt. Die Steuerungseinrichtung SE steuert über ihren Ausgang A-K1 das in der Zeichnung linke Relais K1 an, so dass dieses seine dargestellte Schaltstellung A einnimmt. Der dem in der Zeichnung rechten Relais K2 zugeordnete Ausgang A-K2 der Steuerungseinrichtung SE ist inaktiv, so dass dieses Relais K2 die dargestellte Schaltstellung D einnimmt.

Das an dem in der Zeichnung oberen Ausgang A-MS1 der Motorschaltung MS befindliche positive Potenzial ist somit über den Elektromotor M, die in Schaltstellung F befindliche Schalteinrichtung und die Reihenschaltung der Widerstände R3, R4 des in der Zeichnung rechten Spannungsteilers gegen das Massepotenzial gelegt, so dass an dem Mittenabgriff des Spannungsteilers eine positive Spannung anliegt (im Folgenden "High-Signal" genannt), welche durch die Steuerungseinrichtung SE mittels ihres zweiten Testsignaleingangs E-TS2 erfasst wird.

Da die im Bremsstromkreis befindliche Diode D1 in diesem Schaltzustand sperrend wirkt, fällt an dem in der Zeichnung linken, aus den Widerständen R1, R2 gebildeten Spannungsteiler keine Spannung ab, so dass der dem Mittenabgriff dieses Spannungsteilers zugeordnete, erste Testsignaleingang E-TS1 der Steuerungseinrichtung SE in diesem Betriebszustand kein Signal detektiert (im Folgenden "Low-Signal" genannt).

Der in der Fig. 3 dargestellte, erste Prüfungsschritt bezieht sich somit, unabhängig von dem Bremsstromkreis, allein auf den Motorstromkreis. Ein positives Ergebnis, d.h. High-Signal am zweiten Testsignaleingang E-TS2, Low-Signal am ersten Testsignaleingang E-TS1 der Steuerungseinrichtung SE, bedeutet somit, dass der Motorstromkreis fehlerfrei ist.

Der in der **Fig. 4** dargestellte, einen zweiten Prüfungsschritt enthaltende Betriebszustand der Schaltungsanordnung des Antriebs bezieht den Bremsstromkreis in die Prüfung mit ein. Das von dem Ausgangssignal A-PWM der Steuerungseinrichtung SE für die Motorschaltung MS abhängige Potenzial an dem in der Zeichnung oberen Ausgang A-MS1 der Motorschaltung MS entspricht demjenigen des vorangehend in Fig. 3 beschriebenen Prüfungsschritts, d.h. es ist positiv. Auch die Stellung der Relaiskontakte K1.1, K2.1 der beiden Relais K1, K2, welche von den Signalen der Ausgänge A-K1, A-K2 der Steuerungseinrichtung SE abhängig ist, entspricht derjenigen des vorangehend in Fig. 3 beschriebenen Prüfungsschritts.

Abweichend in dem vorangehend in Fig. 3 beschriebenen Prüfungsschritt ist die Stellung der Schalteinrichtung S1, welche nun die Schaltstellung E einnimmt.

Das an dem in der Zeichnung oberen Ausgang A-MS1 der Motorschaltung MS befindliche positive Potenzial ist somit über den Elektromotor M, die in Schaltstellung E befindliche Schalteinrichtung und die Reihenschaltung der Widerstände R1, R2 des in der Zeichnung linken Spannungsteilers gegen das Massepotenzial gelegt, so dass an dem Mittenabgriff des Spannungsteilers ein High-Signal vorliegt, welches durch die Steuerungseinrichtung SE mittels ihres ersten Testsignaleingangs E-TS1 erfasst wird.

Das an dem in der Zeichnung oberen Ausgang A-MS1 der Motorschaltung MS befindliche positive Potenzial ist außerdem über den Elektromotor M, die in Schaltstellung E befindliche Schalteinrichtung, die leitende Diode D1, den Bremswiderstand RB und die Reihenschaltung der Widerstände R3, R4 des in der Zeichnung rechten Spannungsteilers gegen das Massepotenzial gelegt, so dass auch an dem Mittenabgriff dieses Spannungsteilers ein High-Signal vorliegt, welches durch die Steuerungseinrichtung SE mittels ihres ersten Testsignaleingangs E-TS2 erfasst wird.

Der in der Fig. 4 dargestellte, zweite Prüfungsschritt bezieht sich somit auf die Reihenschaltung des Motorstromkreises mit dem Bremsstromkreis. Ein positives Ergebnis, d.h. High-Signal an beiden Testsignaleingängen E-TS1, E-TS2 der Steuerungseinrichtung SE, bedeutet somit, dass sowohl der Motorstromkreis als auch der Bremsstromkreis in der ersten Bremsrichtung fehlerfrei ist.

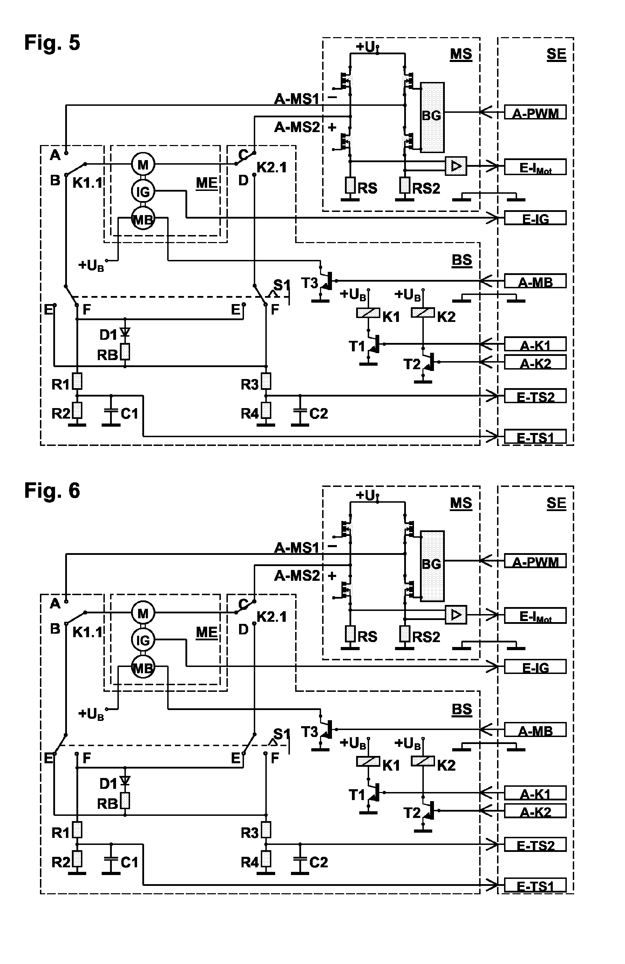

In dem in der Fig. 5 dargestellten, einen dritten Prüfungsschritt enthaltenden Betriebszustand der Schaltungsanordnung des Antriebs wird die zweite Bremsrichtung der Bremsschaltung überprüft. Abweichend von den bisher in den Fig. 3 und 4 dargestellten Prüfungsschritten gibt die Steuerungseinrichtung SE nun über ihren Ausgang A-PWM ein Signal an die Motorschaltung MS aus, welches ein an dem in der Zeichnung unteren Ausgang A-MS2 der Motorschaltung MS befindliches positives Potenzial bewirkt. Auch die Stellung der Relais K1, K2 wird verändert, d.h. der dem in der Zeichnung linken Relais K2 zugeordnete Ausgang A-K2 der Steuerungseinrichtung SE ist inaktiv, so dass dieses Relais K2 die dargestellte Schaltstellung B einnimmt. Die Steuerungseinrichtung SE steuert über ihren Ausgang A-K2 das in der Zeichnung rechte Relais K2 an, so dass dieses seine dargestellte Schaltstellung C einnimmt.

Das an dem in der Zeichnung unteren Ausgang A-MS2 der Motorschaltung MS befindliche positive Potenzial ist somit über den Elektromotor M, die in Schaltstellung F befindliche Schalteinrichtung und die Reihenschaltung der Widerstände R1, R2 des in der Zeichnung linken Spannungsteilers gegen das Massepotenzial gelegt, so dass an dem Mittenabgriff des Spannungsteilers ein High-Signal vorliegt, welches durch die Steuerungseinrichtung SE mittels ihres ersten Testsignaleingangs E-TS1 erfasst wird.

Das an dem in der Zeichnung unteren Ausgang A-MS2 der Motorschaltung MS befindliche positive Potenzial ist außerdem über den Elektromotor M, die in Schaltstellung F befindliche Schalteinrichtung, die leitende Diode D1, den Bremswiderstand RB und die Reihenschaltung der Widerstände R3, R4 des in der Zeichnung rechten Spannungsteilers gegen das Massepotenzial gelegt, so dass auch an dem Mittenabgriff dieses Spannungsteilers ein High-Signal vorliegt, welches durch die Steuerungseinrichtung SE mittels ihres ersten Testsignaleingangs E-TS2 erfasst wird.

Der in der Fig. 5 dargestellte, dritte Prüfungsschritt bezieht sich somit auf die Reihenschaltung des Motorstromkreises mit dem Bremsstromkreis. Ein positives Ergebnis, d.h. High-Signal an beiden Testsignaleingängen E-TS1, E-TS2 der Steuerungseinrichtung SE, bedeutet somit, dass sowohl der Motorstromkreis als auch der Bremsstromkreis auch in der zweiten Bremsrichtung fehlerfrei ist.

Der in der **Fig. 6** dargestellte Betriebszustand der Schaltungsanordnung umfasst einen vierten Prüfungsschritt. Das von dem Ausgangssignal A-PWM der Steuerungseinrichtung SE für die Motorschaltung MS abhängige Potenzial an dem in der Zeichnung unteren Ausgang A-MS2 der Motorschaltung MS entspricht demjenigen des vorangehend in Fig. 5 beschriebenen Prüfungsschritts, d.h. es ist positiv. Auch die Stellung der Relaiskontakte K1.1, K2.1 der beiden Relais K1, K2, welche von den Signalen der Ausgänge A-K1, A-K2 der Steuerungseinrichtung SE abhängig ist, entspricht derjenigen des vorangehend in Fig. 5 beschriebenen Prüfungsschritts.

Abweichend in dem vorangehend in Fig. 5 beschriebenen Prüfungsschritt ist die Stellung der Schalteinrichtung S1, welche nun die Schaltstellung E einnimmt.

Das an dem in der Zeichnung unteren Ausgang A-MS2 der Motorschaltung MS befindliche positive Potenzial ist somit über den Elektromotor M, die in Schaltstellung E befindliche Schalteinrichtung und die Reihenschaltung der Widerstände R3, R4 des in der Zeichnung rechten Spannungsteilers gegen das Massepotenzial gelegt, so dass an dem Mittenabgriff des Spannungsteilers ein High-Signal vorliegt, welches durch die Steuerungseinrichtung SE mittels ihres zweiten Testsignaleingangs E-TS2 erfasst wird.

Da die im Bremsstromkreis befindliche Diode D1 in diesem Schaltzustand sperrend wirkt, fällt an dem in der Zeichnung linken, aus den Widerständen R1, R2 gebildeten Spannungsteiler keine Spannung ab, so dass der dem Mittenabgriff dieses Spannungsteilers zugeordnete, erste Testsignaleingang E-TS1 der Steuerungseinrichtung SE in diesem Betriebszustand ein Low-Signal detektiert.

Der in der Fig. 6 dargestellte, vierte Prüfungsschritt bezieht sich somit, unabhängig von dem Bremsstromkreis, allein auf den Motorstromkreis. Ein positives Ergebnis, d.h. High-Signal am zweiten Testsignaleingang E-TS2 und Low-Signal am ersten Testsignaleingang E-TS1 der Steuerungseinrichtung SE, bedeutet somit, dass der Motorstromkreis auch in der zweiten Bremsrichtung fehlerfrei ist.

Durch die in den Fig. 3 bis 6 dargestellten vier Prüfschritte können also Störungen im Motorstromkreis und Bremsstromkreis lokalisiert werden. Wenn beispielsweise die Ergebnisse des zweiten oder dritten Prüfungsschritts negativ sind, die Ergebnisse des ersten und vierten Prüfungsschritts dagegen positiv, liegt offensichtlich eine Störung im Bremsstromkreis vor, während der Motorstromkreis fehlerfrei ist.

Ein fünfter Prüfungsschritt kann mit der bereits in der Fig. 1 dargestellten Schaltungsanordnung und den dort dargestellten Schaltstellungen A, C der Relaiskontakte K1.1, K2.1 der Relais K1, K2 sowie der Schaltstellung F der Schaltereinrichtung S1 durchgeführt werden, um die Funktionsfähigkeit des Motorstromkreises sowie der mechanischen Bremseinrichtung MB festzustellen.

Über ihren Ausgang A-PWM gibt die Steuerungseinrichtung SE hierzu ein Signal an die Motorschaltung MS aus, welches zwischen den Ausgängen A-MS1, A-MS2 der Motorschaltung MS eine entsprechende Spannung bewirkt. Über die gegen das Massepotenzial geschalteten Shuntwiderstände RS1, RS2 der Motorschaltung MS misst die Steuerungseinrichtung SE mittels ihres Eingangs E-I_{Mot} den Motorstrom. Wird kein Motorstrom gemessen, liegt eine Störung, beispielsweise Unterbrechung des Motorstromkreises vor.

In diesem Prüfungsschritt ist der der mechanischen Bremseinrichtung MB zugeordnete Ausgang A-MB der Steuerungseinrichtung SE aktiv, d.h. über den dann leitenden Transistor T3 ist die Bremseinrichtung MB bestromt und blockiert die Bewegung des Elektromotors M. Die Steuerungseinrichtung SE erfasst mittels ihres Eingangs E-IG das Signal der Drehgebereinrichtung IG. Dieses muss in diesem Prüfungsschritt bei funktionsfähiger Bremseinrichtung MB gleich Null sein; ansonsten liegt eine Störung der Bremseinrichtung MB vor.

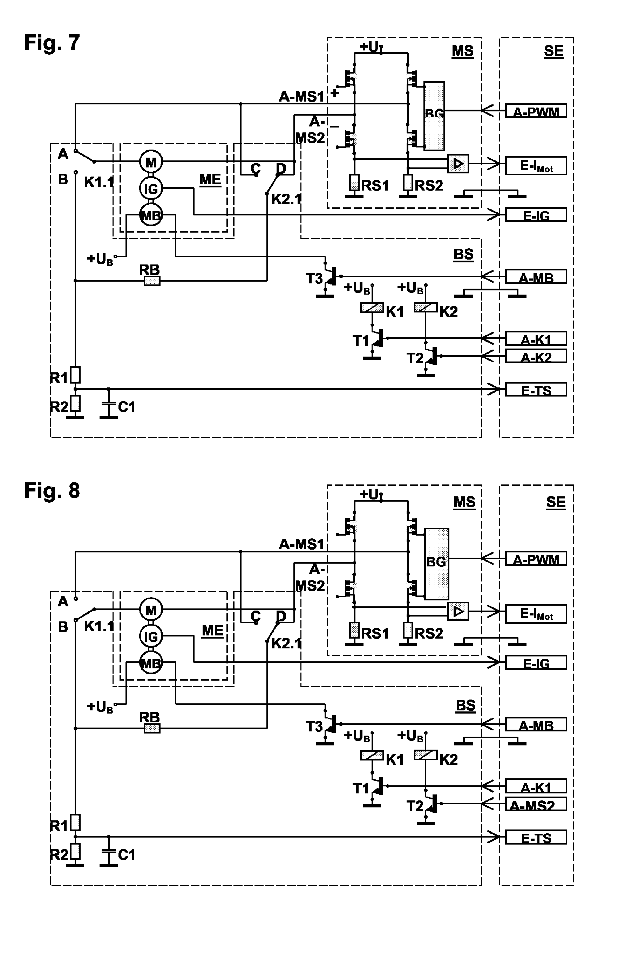

**Fig. 7** zeigt eine gegenüber den vorangehend in den Fig. 1 bis 6 dargestellten Ausführungsbeispielen abweichende Schaltungsanordnung des Antriebs in einem ersten Betriebszustand. Die Bauelemente der Schaltungsanordnung sind, wie in den vorangehend dargestellten Ausführungsbeispielen, mit gestrichelter Umrahmung zu Baueinheiten Motoreinheit ME, Motorschaltung MS, Steuerungseinrichtung SE und Bremsschaltung BS zusammengefasst dargestellt.

Die Steuerungseinrichtung SE, die Motorschaltung MS und die Motoreinheit ME gleichen hierbei den bereits vorangehend dargestellten und beschriebenen Baueinheiten, so dass diesbezüglich auf die Beschreibung zu Fig. 1 verwiesen wird. Lediglich die Bremsschaltung BS ist gegenüber den bereits beschriebenen Ausführungsbeispielen abgewandelt:

Die Ausgangsklemme A-MS1 der Motorschaltung MS ist mit den Relaiskontakten K1.1, K2.1 zweier Relais K1, K2 der Bremsschaltung BS verbunden. Die Relaiskontakte K1.1, K2.1 sind durch die Relais K1, K2 zwischen jeweils zwei Schaltstellungen A, B, C, D umschaltbar. Die Schaltspulen der Relais K1, K2 sind, jeweils in Reihe geschaltet mit der Drain-Source-Strecke eines Transistors T1, T2, zwischen einer Betriebsspannung U_{B} und dem Massepotenzial geschaltet. Die Gate-Anschlüsse der Transistoren T1, T2 sind jeweils mit einem Ausgang A-K1, A-K2 der Steuerungseinrichtung SE verbunden. Bei fehlendem Signal der Ausgänge A-K1, A-K2 sind die Transistoren T1, T2 jeweils sperrend, so dass die Schaltspulen der Relais K1, K2 nicht stromdurchflossen sind. Der Relaiskontakt K1.1 des in der Zeichnung linken Relais K1 befindet sich dann in der in der Zeichnung unteren Schaltstellung B, und der Relaiskontakt K2.1 des in der Zeichnung rechten Relais K2 in der in der Zeichnung rechten Schaltstellung D. Beim Vorliegen eines Ausgangssignals eines oder beider Ausgänge A-K1, A-K2 der Steuerungseinrichtung SE wird die Drain-Source-Strecke des jeweiligen Transistors T1, T2 leitend, was eine Bestromung der Schaltspule des jeweiligen Relais K1, K2 und somit ein Umschalten des jeweiligen Relaiskontakts K1.1, K2.1 von der einen Schaltstellung B, D zu der zweiten Schaltstellung A, C bewirkt.

Die Ausgangsklemme A-MS2 der Motorschaltung MS ist direkt mit dem in der Motoreinheit ME im Motorstromkreis angeordneten, als Gleichstrommotor ausgebildeten Elektromotor M verbunden, dessen Drehzahl mit einer Drehgebereinrichtung IG erfassbar ist. Das Ausgangssignal der Drehgebereinrichtung IG, welche beispielsweise als Inkrementalgeber ausgebildet sein kann, wird dem Eingang E-IG der Steuerungseinrichtung SE zugeleitet, so dass in der Steuerungseinrichtung SE die Drehzahl des Elektromotors und bei hinterlegten Antriebsparametern auch die Stellung des angeschlossenen Flügels erfassbar sind.

Die Motoreinheit ME umfasst außerdem eine mechanische Bremseinrichtung MB, welche mit einer Abtriebswelle des Elektromotors M gekoppelt ist. Die Bremseinrichtung MB kann als Magnetbremse ausgebildet sein, wobei die Spule des Elektromagneten in Reihe mit der Drain-Source-Strecke eines Transistors T3 zwischen einer Betriebsspannung U_{B} und dem Massepotenzial geschaltet ist. Der Gate-Anschluss des Transistors T3 ist mit einem Ausgang A-MB der Steuerungseinrichtung SE verbunden. Bei fehlendem Signal des Ausgangs A-MB ist der Transistor T3 sperrend, so dass die Spule der Magnetbremse nicht stromdurchflossen ist und die Bremse folglich keine Bremswirkung hat. Beim Vorliegen eines Ausgangssignals des Ausgangs A-MB der Steuerungseinrichtung SE wird die Drain-Source-Strecke des Transistors T3 leitend, was eine Bestromung der Spule der Magnetbremse und somit deren Bremswirkung auf den Elektromotor M bewirkt.

Die Bremsschaltung BS weist einen Bremsstromkreis auf, welcher bei der in der Zeichnung unteren Schaltstellung B des Relaiskontakts K1.1 des in der Zeichnung linken Relais K1 in Verbindung mit der in der Zeichnung rechten Schaltstellung D des Relaiskontakts K2.1 des in der Zeichnung rechten Relais K2 mit dem Elektromotor M verbunden ist. Im Bremsstromkreis ist ein Bremswiderstand RB als Lastwiderstand für den generatorisch betriebenen Elektromotor M angeordnet. Der Bremsstromkreis ist in beiden Stromrichtungen wirksam, so dass eine zusätzliche Schaltereinrichtung zur Umkehrung der Polarität des Bremsstromkreises nicht erforderlich ist.

Zur Durchführung von Prüfungen ist in der Bremsschaltung BS außerdem ein Prüfspannungsabgriff vorhanden. Dieser wird gebildet durch einen Spannungsteiler, welcher aus zwei in Reihe geschalteten, hochohmigen Widerständen R1, R2 besteht. Der Spannungsteiler ist zwischen dem Massepotenzial und einem Bezugspunkt des Bremsstromkreises geschaltet, welcher zwischen dem Bremswiderstand RB und dem Relaiskontakt K1.1 des in der Zeichnung linken Relais K1 liegt. Der zwischen den Widerständen R1, R2 des Spannungsteilers befindliche Mittenabgriff ist mit einem Testsignaleingang E-TS der Steuerungseinrichtung SE verbunden. Ein zwischen dem Testsignaleingang E-TS und dem Massepotenzial angeordneter Kondensator C1 glättet die am Testsignaleingang E-TS anliegende Prüfspannung.

Bei dem in dieser Abbildung dargestellten Betriebszustand liegt ein rein elektromotorischer Normalbetrieb des Antriebs vor. Der Ausgang A-K1 der Steuerungseinrichtung SE ist aktiv und bewirkt, dass der Relaiskontakt K1.1 des in der Zeichnung linken Relais K1 die in der Zeichnung obere Schaltstellung A eingenommen hat. Der Elektromotor M ist somit mit den Ausgangsklemmen A-MS1, A-MS2 der Motorschaltung MS verbunden und kann, abhängig vom Signal des Ausgangs A-PWM der Steuerungseinrichtung SE, in beiden Drehrichtungen betrieben werden. Die mechanische Bremseinrichtung MB ist nicht aktiv. Die weiteren Bauelemente der Bremsschaltung BS sind aufgrund der Schaltstellung A des Relaiskontakts K1.1 des Relais K1 vom Elektromotor M elektrisch entkoppelt. Prüfungen der Bremsschaltung BS werden in diesem Betriebszustand nicht vorgenommen.

In der **Fig. 8** ist die vorangehend in Fig. 7 beschriebene Schaltungsanordnung einem zweiten Betriebszustand des Antriebs dargestellt. Die Ausgänge A-K1, A-K2 der Steuerungseinrichtung SE sind jeweils inaktiv, so dass die Transistoren T1, T2 sperrend und die Schaltspulen der Relais K1, K2 nicht stromdurchflossen sind. Die Relaiskontakte K1.1, K2.1 der Relais K1, K2 befinden sich somit in den in der Zeichnung linken, bzw. unteren Schaltstellungen B, D, so dass der Elektromotor M mit dem Bremsstromkreis der Bremsschaltung BS verbunden ist.

Wird eine mechanische Bewegung in das Abtriebsglied des Elektromotors M eingeleitet, beispielsweise durch eine mechanische Energiespeichereinrichtung, wird der Elektromotor M generatorisch betrieben und induziert hierbei eine Spannung, deren Höhe von der Drehzahl des Elektromotors M abhängig ist. Die Motorspannung liegt in dem dargestellten Betriebszustand an dem im Bremsstromkreis befindlichen Bremswiderstand RB an. Der Bremsstrom im Bremsstromkreis ist somit abhängig von der Drehzahl des generatorisch betriebenen Elektromotors M sowie von den Parametern des Bremswiderstands RB.

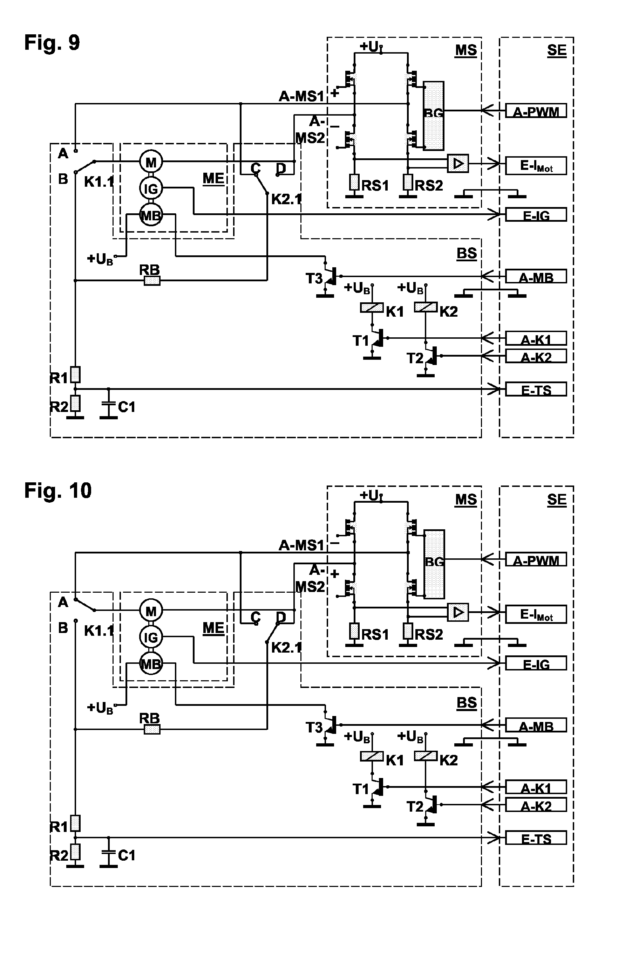

Im Falle einer Störung im Motorstromkreis oder im Bremsstromkreis ist eine Bremswirkung der Bremsschaltung BS nicht mehr gewährleistet, beispielsweise bei einer Unterbrechung einer Leitung der genannten Stromkreise oder im Elektromotor M. Um diese Störungen vor dem Auftreten einer gefährlichen Situation zu detektieren, sind zyklische Prüfungen des Motorstromkreises und des Bremsstromkreises vorgesehen. Die in den folgenden Abbildungen (Fig. 9 und Fig. 10) dargestellten Betriebszustände beinhalten derartige Prüfungen:

In der **Fig. 9** ist ein einen ersten Prüfungsschritt enthaltender Betriebszustand der Schaltungsanordnung des Antriebs dargestellt. Die Steuerungseinrichtung SE aktiviert über ein Ausgangssignal ihres Ausgangs A-MB die mechanische Bremseinrichtung MB, so dass der Elektromotor M in seiner aktuellen Position blockiert wird. Über ihren Ausgang A-PWM gibt die Steuerungseinrichtung SE ein Signal an die Motorschaltung MS aus, welches eine zwischen den Ausgängen A-MS1, A-MS2 der Motorschaltung MS anliegende Spannung bewirkt. Die Steuerungseinrichtung SE steuert über ihren Ausgang A-K2 das in der Zeichnung rechte Relais K2 an, so dass dieses seine dargestellte Schaltstellung C einnimmt. Der dem in der Zeichnung linken Relais K1 zugeordnete Ausgang A-K1 der Steuerungseinrichtung SE ist inaktiv, so dass dieses Relais K1 die dargestellte Schaltstellung B einnimmt.

Die zwischen den Ausgängen A-MS1, A-MS2 der Motorschaltung MS anliegende Spannung liegt somit an einer Reihenschaltung des Bremswiderstands RB und des Elektromotors M. Der Stromfluss durch diese Reihenschaltung wird über die gegen das Massepotenzial geschalteten Shuntwiderstände RS1, RS2 der Motorschaltung MS durch die Steuerungseinrichtung SE mittels ihres Eingangs E-I_{Mot} gemessen.

Da die Parameter der Bauelemente (d.h. der Innenwiderstand des Elektromotors M, die Zwischenkreisspannung der Motorschaltung MS, das Tastverhältnis des Signals des Ausgangs A-PWM der Steuerungseinrichtung SE sowie der maximale Wert des Bremswiderstands RB) in der Steuerungseinrichtung SE hinterlegt sind, kann in der Steuerungseinrichtung SE aus dem gemessenen Strom der tatsächliche Wert des Bremswiderstands RB berechnet und mit dem gespeicherten Sollwert verglichen werden. Bei Abweichungen außerhalb eines vordefinierten Toleranzbereiches erfolgt eine Sicherheitsreaktion des Antriebs, beispielsweise dessen Außerbetriebnahme sowie die Generierung und ggf. Aussendung einer Fehlermeldung.

Ein zweiter Prüfungsschritt kann mit der bereits in der Fig. 7 dargestellten Schaltungsanordnung und den dort dargestellten Schaltstellungen A, D der Relaiskontakte K1.1, K2.1 der Relais K1, K2 durchgeführt werden, um die Funktionsfähigkeit des Motorstromkreises sowie der mechanischen Bremseinrichtung MB festzustellen.

Über ihren Ausgang A-PWM gibt die Steuerungseinrichtung SE hierzu ein Signal an die Motorschaltung MS aus, welches zwischen den Ausgängen A-MS1, A-MS2 der Motorschaltung MS eine entsprechende Spannung bewirkt. In diesem Prüfungsschritt wird das Signal des Ausgangs A-PWM der Steuerungseinrichtung SE so gewählt, dass der in der Zeichnung obere Ausgang A-MS1 der Motorschaltung MS ein gegenüber dem in der Zeichnung unteren Ausgang A-MS2 der Motorschaltung sowie gegenüber dem Massepotenzial positives Potenzial aufweist. Über die gegen das Massepotenzial geschalteten Shuntwiderstände RS1, RS2 der Motorschaltung MS misst die Steuerungseinrichtung SE mittels ihres Eingangs E-I_{Mot} den Motorstrom. Wird kein Motorstrom gemessen, liegt eine Störung, beispielsweise eine Unterbrechung des Motorstromkreises vor.

In diesem Prüfungsschritt ist der der mechanischen Bremseinrichtung MB zugeordnete Ausgang A-MB der Steuerungseinrichtung SE aktiv, d.h. über den dann leitenden Transistor T3 ist die Bremseinrichtung MB bestromt und blockiert die Bewegung des Elektromotors M. Die Steuerungseinrichtung SE erfasst mittels ihres Eingangs E-IG das Signal der Drehgebereinrichtung IG. Dieses muss in diesem Prüfungsschritt bei funktionsfähiger Bremseinrichtung MB gleich Null sein; ansonsten liegt eine Störung der Bremseinrichtung MB vor.

Ein einen dritten Prüfungsschritt enthaltender Betriebszustand der Schaltungsanordnung des Antriebs ist in der **Fig. 10** dargestellt. Die Schaltstellungen A, D der Relaiskontakte K1.1, K2.1 der beiden Relais K1, K2 entsprechen denjenigen der Ausführungsbeispiele der Fig. 7 und 9. Abweichend wird in diesem Prüfungsschritt das Signal des Ausgangs A-PWM der Steuerungseinrichtung SE so gewählt, dass der in der Zeichnung untere Ausgang A-MS2 der Motorschaltung MS ein gegenüber dem in der Zeichnung oberen Ausgang A-MS1 der Motorschaltung sowie gegenüber dem Massepotenzial positives Potenzial aufweist. Über die gegen das Massepotenzial geschalteten Shuntwiderstände RS1, RS2 der Motorschaltung MS misst die Steuerungseinrichtung SE mittels ihres Eingangs E-I_{Mot} den Motorstrom. Wird kein Motorstrom gemessen, liegt eine Störung, beispielsweise eine Unterbrechung des Motorstromkreises vor.

Auch in diesem Prüfungsschritt ist der der mechanischen Bremseinrichtung MB zugeordnete Ausgang A-MB der Steuerungseinrichtung SE aktiv, d.h. über den dann leitenden Transistor T3 ist die Bremseinrichtung MB bestromt und blockiert die Bewegung des Elektromotors M. Die Steuerungseinrichtung SE erfasst mittels ihres Eingangs E-IG das Signal der Drehgebereinrichtung IG. Dieses muss in diesem Prüfungsschritt bei funktionsfähiger Bremseinrichtung MB gleich Null sein; ansonsten liegt eine Störung der Bremseinrichtung MB vor.

Aufgrund des gegenüber dem Massepotenzial positiven Potenzials des in der Zeichnung unteren Ausgangs A-MS2 der Motorschaltung MS liegt an dem Mittenabgriff des aus den Widerständen R1, R2 gebildeten Spannungsteilers ein High-Signal vor, welches durch die Steuerungseinrichtung SE mittels ihres ersten Testsignaleingangs E-TS erfasst wird.

### Liste der Referenzzeichen

- A: Schaltstellung
- A-K1: Ausgang
- A-K2: Ausgang
- A-MB: Ausgang
- A-PWM: Ausgang
- B: Schaltstellung
- BG: Brückengleichrichter
- BS: Bremsschaltung
- C: Schaltstellung
- C1: Kondensator
- C2: Kondensator
- D: Schaltstellung
- D1: Diode
- E: Schaltstellung
- E-Iₘₒₜ: Eingang
- E-IG: Eingang
- E-TS: Testsignaleingang
- E-TS1: Testsignaleingang
- E-TS2: Testsignaleingang
- F: Schaltstellung
- IG: Drehgebereinrichtung
- K1: Relais
- K2: Relais
- K1.1: Relaiskontakt
- K2.1: Relaiskontakt
- M: Elektromotor
- MB: Bremseinrichtung
- ME: Motoreinheit
- MS: Motorschaltung
- R1: Widerstand
- R2: Widerstand
- R3: Widerstand
- R4: Widerstand
- RB: Bremswiderstand
- RS1: Shuntwiderstand
- RS2: Shuntwiderstand
- S1: Schaltereinrichtung
- SE: Steuerungseinrichtung
- T1: Transistor
- T2: Transistor
- T3: Transistor
- U: Spannung
- U_{B}: Betriebsspannung

## Patentansprüche

1. Antrieb zum Betätigen eines beweglichen Flügels, insbesondere einer Tür, mit einem in einem Motorstromkreis angeordneten Elektromotor (M), dessen Abtriebsglied über eine Kraftübertragungseinrichtung mit dem Flügel in Wirkverbindung steht, so dass eine Bewegung des Abtriebsglieds eine Bewegung des Flügels bewirkt, sowie
mit einer Steuerungseinrichtung (SE) zur Ansteuerung des Elektromotors (M),
mit einer Bremseinrichtung (MB), durch welche die Bewegung des Flügels bremsbar ist, indem der Elektromotor (M) als Generator betreibbar ist, und
wobei die Ausgangsspannung des generatorisch betriebenen Elektromotors (M) an einen in einem Bremsstromkreis angeordneten, elektrischen Widerstand angelegt wird,
**dadurch gekennzeichnet,**
**dass** die Steuerungseinrichtung (SE) so ausgebildet ist, dass zyklische Prüfungen des Motorstromkreises und des Bremsstromkreises durchführbar sind,
wobei bei Erkennung einer Störung des Motorstromkreises bzw. des Bremsstromkreises eine Sicherheitsreaktion erfolgt.

2. Antrieb nach Anspruch 1,
**dadurch gekennzeichnet , dass** die Steuerungseinrichtung (SE) mindestens einen Testsignaleingang (E-TS1, E-TS2) für ein bei der Prüfung des Motorstromkreises bzw. des Bremsstromkreises generierbares Testsignal aufweist.

3. Antrieb nach Anspruch 1,
**dadurch gekennzeichnet , dass** die Bremsschaltung (BS) mindestens eine Umschalteinrichtung aufweist, durch welche der Motorstromkreis mit dem Bremsstromkreis elektrisch verbindbar oder von diesem entkoppelbar ist.

4. Antrieb nach Anspruch 3,
**dadurch gekennzeichnet , dass** die Umschalteinrichtung mindestens ein Relais (K1, K2) mit einem Relaiskontakt (K1.1, K2.1) aufweist.

5. Antrieb nach Anspruch 4,
**dadurch gekennzeichnet , dass** die Steuerungseinrichtung (SE) mindestens einen Ausgang (A-K1, A-K2) zur Ansteuerung des Relais (K1, K2) aufweist.

6. Antrieb nach Anspruch 1,
**dadurch gekennzeichnet , dass** die Bremsschaltung (BS) mindestens eine Umschalteinrichtung aufweist, durch welche die Stromrichtung im Bremsstromkreis umschaltbar ist.

7. Antrieb nach Anspruch 6,
**dadurch gekennzeichnet , dass** die Umschalteinrichtung mindestens eine im Bremsstromkreis angeordnete, als Umschalter ausgebildete Schaltereinrichtung (S1) aufweist.

8. Antrieb nach Anspruch 1,
**dadurch gekennzeichnet , dass** die Bremsschaltung (BS) mindestens einen aus mindestens zwei in Reihe geschalteten Widerständen (R1, R2, R3, R4) gebildeten Spannungsteiler aufweist.

9. Antrieb nach Anspruch 8,
**dadurch gekennzeichnet , dass** der Spannungsteiler zwischen dem Bremsstromkreis und dem Massepotenzial angeordnet ist.

10. Antrieb nach Anspruch 9,
**dadurch gekennzeichnet , dass** parallel zu dem zwischen dem Mittenabgriff und dem Massepotenzial angeordneten Widerstand (R2, R4) des Spannungsteilers mindestens ein Kondensator (C1, C2) angeordnet ist.

11. Antrieb nach den Ansprüchen 2 und 8,
**dadurch gekennzeichnet , dass** der Testsignaleingang (E-TS1, E-TS2) der Steuerungseinrichtung (SE) mit dem Mittenabgriff des Spannungsteilers verbunden ist.

12. Antrieb nach Anspruch 1,
**dadurch gekennzeichnet , dass** die Steuerungseinrichtung (SE) mindestens einen Ausgang (A-PWM) zur Ansteuerung des Elektromotors (M) aufweist.

13. Antrieb nach Anspruch 12,
**dadurch gekennzeichnet , dass** das Ausgangssignal des zur Ansteuerung des Elektromotors (M) dienenden Ausgangs (A-PWM) der Steuerungseinrichtung (SE) zur Prüfung des Motorstromkreises bzw. Bremsstromkreises verwendet wird.

14. Antrieb nach Anspruch 1,
**dadurch gekennzeichnet , dass** die Abtriebswelle des Elektromotors (M) mit einer Bremseinrichtung (MB) verbunden ist.

15. Antrieb nach Anspruch 1,
**dadurch gekennzeichnet , dass** die Steuerungseinrichtung (SE) mindestens einen Ausgang (A-MB) zur Ansteuerung der Bremseinrichtung (MB) aufweist.

16. Antrieb nach Anspruch 1,
**dadurch gekennzeichnet , dass** die Abtriebswelle des Elektromotors (M) mit einer Drehgebereinrichtung (IG) verbunden ist.

17. Antrieb nach Anspruch 1,
**dadurch gekennzeichnet , dass** die Steuerungseinrichtung (SE) mindestens einen Eingang (E-IG) für ein Signal der Drehgebereinrichtung (IG) aufweist.

18. Antrieb nach Anspruch 1,
**dadurch gekennzeichnet , dass** die Steuerungseinrichtung (SE) mindestens einen Eingang (E-I_{Mot}) für ein den den Elektromotor (M) durchfließenden Strom anzeigendes Signal aufweist.
